# EUROPEAN PATENT APPLICATION

(11) **EP 2 083 452 A1**
(43) Date of publication of application: **29.07.2009**
(21) Application number: 08017412.1
(22) Date of filing: 02.10.2008
(51) Int. Cl.: H01L 31/068, H01L 31/0304, H01L 31/18, H01L 31/0224

(54) **High concentration terrestrial solar cell arrangement with III-V compound semiconductor cell**

(30) Priority: 25.01.2008 US 20283; 18.04.2008 US 148553
(71) Applicant: Emcore Solar Power, Inc., Albuquerque NM 87123 (US)
(72) Inventor: Aiken, Daniel J., Cedar Crest NM 87007 (US); Stan, Mark A, Albuquerque NM 87122 (US); Newman, Fred, Albuquerque NM 87108 (US)
(74) Representative: Wagner, Karl H.

(57) **Abstract**

A concentrator photovoltaic solar cell arrangement for producing energy from the sun comprising a concentrating lens for producing a light concentration of greater than 500X; and a solar cell in the path of the concentrated light beam; including a germanium substrate including a first photoactive junction and forming a bottom solar subcell; a gallium arsenide middle subcell disposed on said substrate; an indium gallium phosphide top subcell disposed over said middle subcell and having a bandgap to maximize absorption in the AM1.5 spectral region; a thickness greater than 7000 Angstroms; and a sheet resistance of less than 330 ohms/square, and adapted to operate at a concentration level of greater than twenty suns, wherein the current density of the top subcell is greater than 35 amps/square centimeter.

## Description

### BACKGROUND OF THE INVENTION

### 1. Field of the Invention

The present invention relates generally to the design of solar cells for concentrator terrestrial solar power systems for the conversion of sunlight into electrical energy, and, more particularly to an arrangement including a concentrator lens and a solar cell using III-V compound semiconductors, and the optimization of the optical concentration level on the solar cell.

### Description of the Related Art

Commercially available silicon solar cells for terrestrial solar power application have efficiencies ranging from 8% to 15%. Compound semiconductor solar cells, based on III-V compounds, have 28% efficiency in normal operating conditions. Moreover, it is well known that concentrating solar energy onto a III-V compound semiconductor photovoltaic cell increases the cell's efficiency to over 37% efficiency under concentration.

Terrestrial solar power systems currently use silicon solar cells in view of their low cost and widespread availability. Although III-V compound semiconductor solar cells have been widely used in satellite applications, in which their power-to-weight efficiencies are more important than cost-per-watt considerations in selecting such devices, such solar cells are designed for the solar spectrum at the top of the earth's atmosphere (known as air mass 0, or AMO), and are not suitable for coverage of the solar spectrum present at the earth's surface (known as air mass 1.5 or AM1.5). The AMO cells also have not been configured for use in terrestrial, solar tracking, concentrator photovoltaic systems.

In the design of both silicon and III-V compound semiconductor solar cells, one electrical contact is typically placed on a light absorbing or front side of the solar cell and a second contact is placed on the back side of the cell. A photoactive semiconductor is disposed on a light-absorbing side of the substrate and includes one or more p-n junctions, which creates electron flow as light is absorbed within the cell. Grid lines extend over the top surface of the cell to capture this electron flow which then connect into the front contact or bonding pad.

An important aspect of specifying the design of a solar cell is the physical structure (composition, bandgaps, and layer thicknesses) of the semiconductor material layers constituting the solar cell. Solar cells are often fabricated in vertical, multijunction structures to utilize materials with different bandgaps and convert as much of the solar spectrum as possible. One type of multijunction structure useful in the design according to the present invention is the triple junction solar cell structure consisting of a germanium bottom cell, a gallium arsenide (GaAs) middle cell, and an indium gallium phosphide (InGaP) top cell.

Prior to the present invention, there has not been a consideration of the effect of concentration levels incident on a triple junction III-V compound semiconductor solar cell suitable for terrestrial applications, or a determination of the concentration levels to maximize efficiency of the cell.

### SUMMARY OF THE INVENTION

### 1. Objects of the Invention

It is an object of the present invention to provide an improved III-V compound semiconductor multijunction solar cell for terrestrial power applications producing in excess of 15 watts of peak DC power per solar cell.

It is still another object of the invention to provide a grid structure on the front surface of a III-V semiconductor solar cell to accommodate high current for concentrator photovoltaic terrestrial power applications.

It is still another object of the invention to provide a III-V semiconductor solar cell with a relatively thick front or top subcell semiconductor layers having a composition optimized for high concentration AM1.5 solar radiation for terrestrial power applications.

It is still another object of the invention to provide a terrestrial solar power system constituted by a plurality of solar cell arrays with concentration optics adapted to permit the solar cells to operate at maximum efficiency.

### 2. Features of the Invention

Briefly, and in general terms, the present invention provides a concentrator photovoltaic solar cell for producing energy from the sun including a germanium substrate including a first photoactive junction and forming a bottom solar subcell; a gallium arsenide middle subcell disposed on said substrate; an indium gallium phosphide top subcell disposed over the middle subcell and having a bandgap to maximize absorption in the AM1.5 spectral region and further having a thickness greater than 7000 Angstroms and a sheet resistance of less than 330 ohms/square adapted to operate at a concentration level of greater than twenty suns, wherein the current density of the top subcell is greater than 35 amps/square centimeter; and a surface grid disposed over the top subcell and having a grid pattern which covers approximately 5% of the top subcell surface area and is adapted for conduction of the relatively high current created by the solar cell.

In another aspect, the present invention provides a concentrator photovoltaic solar cell for producing energy from the sun including a bottom subcell including a first photoactive junction, a middle subcell disposed on said bottom subcell and including a second photoactive junction; and a top subcell disposed over said middle subcell and having a photoactive junction and bandgap to maximize absorption in the AM1.5 spectral region with a top layer sheet resistance of less than 500 ohms/square and adapted operate at an concentration level of greater than twenty suns.

In another aspect, the present invention provides a concentrator photovoltaic solar cell for producing energy from the sun including a germanium substrate including a first photoactive junction a gallium arsenide middle subcell disposed on said substrate; and an indium gallium phosphide top subcell disposed over said middle subcell and having a bandgap to maximize absorption in the AM 1.5 spectral region and a thickness greater than 7000 Angstroms in order to carry the increased current associated with concentrated sunlight on the surface of said top subcell.

### BRIEF DESCRIPTION OF THE DRAWINGS

FIG. 1 is a highly enlarged cross-sectional view of a terrestrial solar cell constructed in accordance with the present invention;
FIG. 2 is a top plan view of the solar cell of FIG. 1 showing the grid lines in a first embodiment;
FIG. 3 is a top plan view of the solar cell of FIG. 1 showing the grid lines in a second embodiment;
FIG. 4 is a graph showing the efficiency of a solar cell having a structure according to the present invention as a function of the surface coverage of the grid lines; and
FIG. 5 is a graph showing the efficiency of a solar cell having a structure according to the present invention as a function of the solar concentration level on the surface of the cell.

Additional objects, advantages, and novel features of the present invention will become apparent to those skilled in the art from this disclosure, including the following detailed description as well as by practice of the invention. While the invention is described below with reference to a preferred embodiment, it should be understood that the invention is not limited thereto. Those of ordinary skill in the art having access to the teachings herein will recognize additional applications, modifications and embodiments in other fields, which are within the scope of the invention as disclosed and claimed herein and with respect to which the invention could be of utility.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The design of a typical semiconductor structure of a triple junction III-V compound semiconductor solar cell is more particularly described in U.S. Patent No. 6,680,432, herein incorporated by reference. Since such cells are described as optimized for space (AM0) solar radiation, one aspect of the present invention is the modification or adaptation of such cell designs for concentrator photovoltaic applications with terrestrial (AM1.5) solar spectrum radiation according to the present invention.

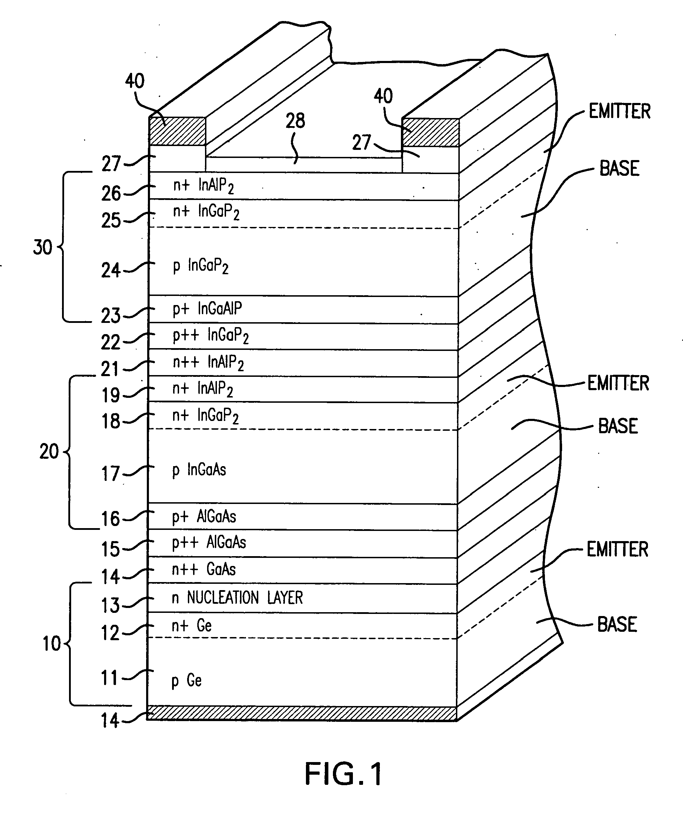

As shown in the illustrated example of FIG. 1, the bottom subcell 10 includes a substrate 11, 12 formed of p-type germanium ("Ge"), the bottom portion which also serves as a base layer of the subcell 10. A metal contact layer or pad 14 is formed on the bottom of base layer 11 to provide an electrical contact to the multijunction solar cell. The bottom subcell 10 further includes, for example, an n-type Ge emitter region 12, and an n-type nucleation layer 13. The nucleation layer 13 is deposited over the substrate 11, 12, and the emitter layer 12 is formed in the Ge substrate by diffusion of dopants from upper layers into the Ge substrate, thereby changing upper portion 12 of the p-type germanium substrate to an n-type region 12. A heavily doped n-type gallium arsenide layer 14 is deposited over the nucleation layer 13, and is a source of arsenic dopants into the emitter region 12.

Although the growth substrate and base layer 11 is preferably a p-type Ge growth substrate and base layer, other semiconductor materials may be also be used as the growth substrate and base layer, or only as a growth substrate. Examples of such substrates include, but not limited to, GaAs, InP, GaSb, InAs, InSb, GaP, Si, SiGe, SiC, Al₂O₃, Mo, stainless steel, soda-lime glass, and SiO₂

Heavily doped p-type aluminum gallium arsenide ("AlGaAs") and ("GaAs") tunneling junction layers 14, 15 may be deposited over the nucleation layer 13 to form a tunnel diode and provide a low resistance pathway between the bottom subcell and the middle subcell 20.

The middle subcell 20 includes a highly doped p-type aluminum gallium arsenide ("A1GaAs") back surface field ("BSF") layer 16, a p-type InGaAs base layer 17, a highly doped n-type indium gallium phosphide ("InGaP₂") emitter layer 18 and a highly doped n-type indium aluminum phosphide ("AlInP₂") window layer 19.

The window layer typically has the same doping type as the emitter, but with a higher doping concentration than the emitter. Moreover, it is often desirable for the window layer to have a higher band gap than the emitter, in order to suppress minority-carrier photogeneration and injection in the window, thereby reducing the recombination that would otherwise occur in the window layer. Note that a variety of different semiconductor materials may be used for the window, emitter, base and/or BSF layers of the photovoltaic cell, including A1InP, A1As, A1P, A1GaInP, A1GaAsP, A1GaInAs, A1GaInPAs, GaInP, GaInAs, GaInPAs, A1GaAs, A1InAs, A1InPAs, GaAsSb, A1AsSb, GaAlAsSb, A1InSb, GaInSb, A1GaInSb, AlN, GaN, InN, GaInN, A1GaInN, GaInNAs, A1GaInNAs, ZnSSe, CdSSe, and other materials and still fall within the spirit of the present invention.

The InGaAs base layer 17 of the middle subcell 307 can include, for example, approximately 1.5% Indium. Other compositions may be used as well. The base layer 17 is formed over the BSF layer 16 after the BSF layer is deposited over the tunneling junction layers 14, 15 of the bottom subcell 10.

The BSF layer 16 is provided to reduce the recombination loss in the middle subcell 20. The BSF layer 16 drives minority carriers from a highly doped region near the back surface to minimize the effect of recombination loss. Thus, the BSF layer 16 reduces recombination loss at the backside of the solar cell and thereby reduces recombination at the base layer/BSF layer interface. The window layer 19 is deposited on the emitter layer 18 of the middle subcell 20 after the emitter layer is deposited. The window layer 19 in the middle subcell 20 also helps reduce the recombination loss and improves passivation of the cell surface of the underlying junctions.

Before depositing the layers of the top subcell 30, heavily doped n-type InA1P₂ and p-type InGaP₂ tunneling junction layers 21, 22 respectively may be deposited over the middle subcell 20, forming a tunnel diode.

The tunnel diode layers disposed between subcells have a thickness adapted to support a current density through the tunnel diodes of greater than 50 amps/square centimeter. In operation the current density of the top subcell is greater than 35 amps/square centimeter.

In the illustrated example, the top subcell 30 includes a highly doped p-type indium gallium aluminum phosphide ("InGaA1P") BSF layer 23, a p-type InGaP₂ base layer 24, a highly doped n-type InGaP₂ emitter layer 25 and a highly doped n-type InA1P₂ window layer 26. The base layer 24 of the top subcell 30 is deposited over the BSF layer 23 after the BSF layer 23 is formed over the tunneling junction layers 21, 22 of the middle subcell 20. The window layer 26 is deposited over the emitter layer 25 of the top subcell after the emitter layer 25 is formed over the base layer 24. A cap layer 27 may be deposited and patterned into separate contact regions over the window layer 26 of the top subcell 30.

The cap layer 27 serves as an electrical contact from the top subcell 309 to metal grid layer 40. The sheet resistance of the top subcell is preferably about 250 ohms/square centimeters, and in any event less than 330 ohms/square. In some implementations, the top subcell has a thickness greater than 7000 Angstroms, a sheet resistance of less than 330 ohms/square, and is adapted to operate at a concentration level of greater than twenty suns. In operation, the current density of the top subcell is greater than 35 amps/square centimeter. The doped cap layer 27 can be a semiconductor layer such as, for example, a GaAs or InGaAs layer. An anti-reflection coating 28 can also be provided on the surface of window layer 26 in between the contact regions of cap layer 27.

The resulting solar cell has band gaps of 1.9 eV, 1.4 eV, and 0.7 eV for the top, middle, and bottom subcells, respectively. The solar cell has an open circuit voltage (V_{oc}) of at least 3.0 volts, a responsivity at short circuit at least 0.13 amps per watt, a fill factor (FF) of at least 0.70, and an efficiency at least 35% under air mass 1.5 (AM1.5) or similar terrestrial spectrum at 25 degrees Centigrade, when illuminated by concentrated sunlight by a factor in excess of 500X, so as to produce in excess of 15 watts of DC power.

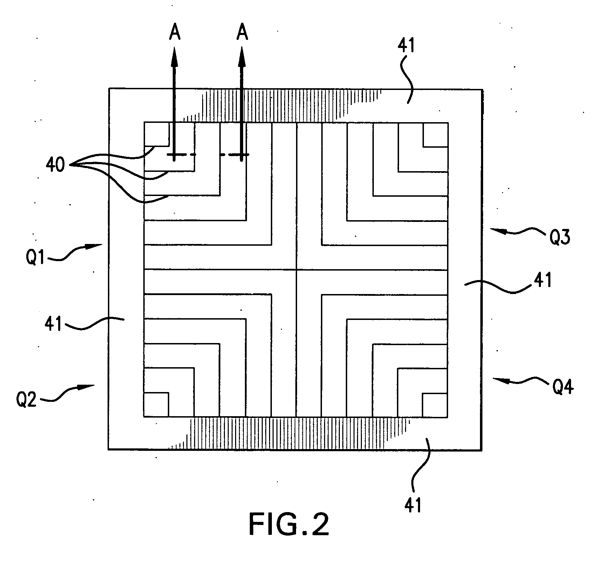

FIG. 2 is a top plan view of the solar cell of FIG. 1 showing the grid lines 40 in a first embodiment. In particular, FIG. 1 depicts the cross-section through the A-A plane of FIG. 2, including two typical grid lines 40. The grid lines 40 are arranged into four identical quadrants Q1, Q2, Q3 and Q4 over the active area of the solar cell. It is noted that in this embodiment the cell is four-fold rotationally symmetric, i.e. the cell can be rotated 90° and each configuration of the grid lines in the cell after rotation is identical to the previous configuration of the grid lines prior to rotation.

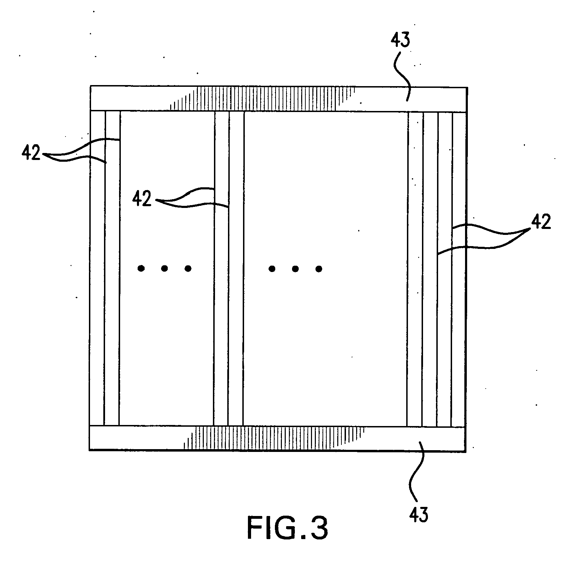

FIG. 3 is a top plan view of the solar cell of FIG. 1 showing the grid lines in a second embodiment. In particular, the grid lines extend between two bus bars on opposite sides of the cell. Either the first or the second embodiments, have a thickness or height of 4 microns or more, a width of less than 5 microns, and a pitch (i.e., distance between centers of adjacent grid lines) of greater than 100 micron but less than 200 microns.

The aggregate surface area of the grid pattern covers approximately 2.0% to 5.0% of the surface area of the top subcell. In some implementations, the aggregate surface area of the grid pattern covers approximately 5.0% of the surface area of the top subcell. The grid pattern and line dimensions are selected to carry the relatively high current produced by the solar cell.

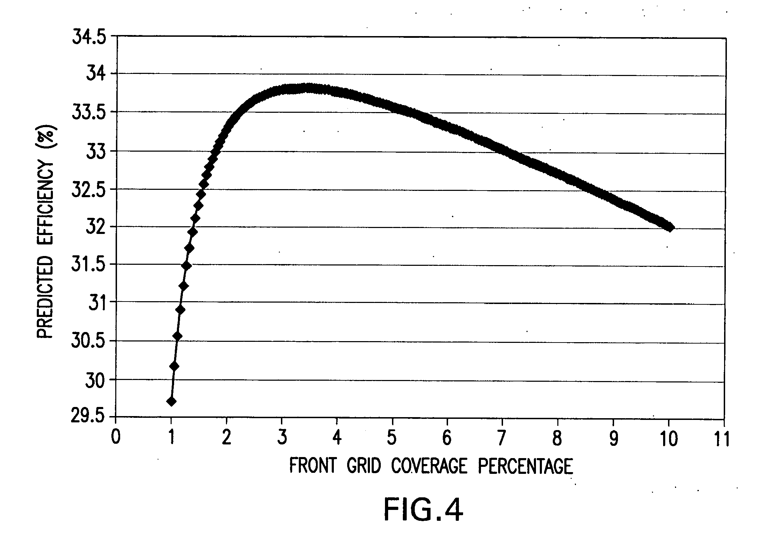

FIG. 4 is a graph showing the efficiency of a solar cell having a structure according to the present invention as a function of the surface coverage of the grid lines as a percent of the total surface area of the solar cell. The graph peaks in the range of 2 to 5% of the surface area, and thus according to one aspect of the present invention, the surface coverage of the grid lines is selected in that range (e.g., approximately 5%)..

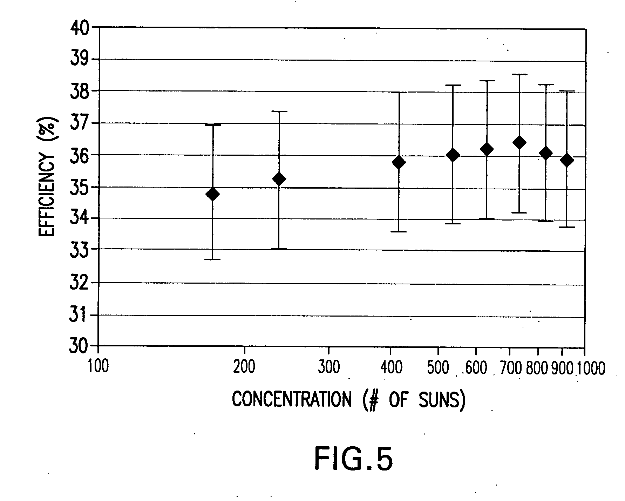

FIG. 5 is a graph showing the efficiency of a solar cell having a structure according to the present invention as a function of the concentration of light measured as the number of suns of light intensity incident on the surface of the solar cell. Stated another way, the efficiency is a function of the power of the concentration optics. The graph peaks in the range of 600X to 800X, and thus according to one aspect of the present invention, irrespective of other factors, the optimum value for the concentrator optics should be selected in that range.

The difficulty with the teaching of the graph in Figure 5 is that as the intensity of light on the surface of the solar cell increases, the temperature of the cell increases. Increased temperature requires greater cooling or heat dissipation from the cell in order for it to operate within normal operating specifications (i.e. from 40 to 50 degrees Centigrade above the ambient temperature).

Although the invention has been described in certain specific embodiments of semiconductor structures, and grid designs, many additional modifications and variations would be apparent to those skilled in the art.

For example, the present invention may utilize one or more homojunction cells or subcells, i.e., a cell or subcell in which the p-n junction is formed between a p-type semiconductor and an n-type semiconductor both of which have the same chemical composition and the same band gap, differing only in the dopant species and types. Alternatively, the present invention may utilize one or more heterojunction cells or subcells, i.e., a cell or subcell in which the p-n junction is formed between a p-type semiconductor and an n-type semiconductor having different chemical compositions of the semiconductor material in the n-type and n-type regions, and/or different band gap energies in the p-type regions, in addition to utilizing different dopant species and type in the p-type and n-type regions that form the p-n junction. This aspect of the present invention is, therefore, considered in all respects to be illustrative and not restrictive. The scope of this aspect of the invention is indicated by the relevant appended claims, and all changes that come within the meaning and range of equivalents thereof are intended to be embraced therein.

It will be understood that each of the elements described above, or two or more together, also may find a useful application in other types of terrestrial solar cell systems and constructions differing from the types described above.

While the aspect of the invention has been illustrated and described as embodied in a solar cell semiconductor structure using III-V compound semiconductors, it is not intended to be limited to the details shown, since various modifications and structural changes may be made without departing in any way from the spirit of the present invention.

## Claims

1. A concentrator photovoltaic solar cell arrangement for producing energy from the sun comprising:
a concentrating lens for producing a light concentration of greater than 500X; and
a solar cell in the path of the concentrated light beam; including
a germanium substrate including a first photoactive junction and forming a bottom solar subcell;
a gallium arsenide middle subcell disposed on said substrate;
an indium gallium phosphide top subcell disposed over said middle subcell and having a bandgap to maximize absorption in the AM1.5 spectral region; a thickness greater than 7000 Angstroms; and a sheet resistance of less than 330 ohms/square, and adapted to operate at a concentration level of greater than twenty suns, wherein the current density of the top subcell is greater than 35 amps/square centimeter.

2. An arrangement as defined in claim 1, further comprising
a surface grid disposed over said top cell and having a grid pattern which covers approximately 2.5% to 5% of the top cell surface area.

3. An arrangement as defined in claim 2, wherein the grid pattern comprises lines having a width of 5 microns or less.

4. An arrangement as claimed in claim 2, wherein the grid pattern includes lines having a thickness of greater than 4 microns, and a center-to-center pitch of greater than 100 microns.

5. An arrangement as claimed in claim 2, wherein the grid pattern consists of a plurality of parallel grid lines covering the top surface.

6. An arrangement as claimed in claim 1, wherein the solar cell has an open circuit voltage (V_{oc}) of at least 3.0 volts, a responsivity at short circuit at least 0.13 amps per watt, a fill factor (FF) of at least 0.70, and produces in excess of 10 watts of DC power at AM1.5 solar irradiation with conversion efficiency in excess of 35%.

7. An arrangement as claimed in claim 1, wherein the bandgap of the top, middle, and bottom subcells are approximately 1.9 eV, 1.4 eV, and 0.7 eV respectively.

8. An arrangement as claimed in claim 1, wherein the thickness of the semiconductor layers of the top subcell is one micron or greater.

9. An arrangement as claimed in claim 1, further comprising a first tunnel diode disposed between said bottom and said middle subcells, and a second tunnel diode disposed between said middle and said top subcells, each tunnel diode capable of supporting a current density of greater than 50 amps/square centimeter.

10. An arrangement as claimed in claim 2, wherein the sheet resistance and the surface area coverage of the grid pattern are selected to maximize the fill factor.
